Europäisches Patentamt

European Patent Office

Office européen des brevets

(19)

(11) **EP 1 086 777 A1**

(12) **EUROPÄISCHE PATENTANMELDUNG**

(43) Veröffentlichungstag:
**28.03.2001 Patentblatt 2001/13**

(51) Int Cl.⁷: **B23K 20/10**

(21) Anmeldenummer: **00810840.9**

(22) Anmeldetag: **18.09.2000**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **23.09.1999 EP 99810856**

(71) Anmelder: **Esec Trading S.A.**
**6330 Cham (CH)**

(72) Erfinder: **Felber, Armin**
**6003 Luzern (CH)**

(74) Vertreter: **Falk, Urs, Dr.**
**Patentanwaltsbüro Dr. Urs Falk,**
**Eichholzweg 9A**
**6312 Steinhausen (CH)**

(54) **Ultraschalldrahtbonder mit einem Sensor für die Regelung der Bondkraft**

(57) Ein Ultraschalldrahtbonder (1) zur Herstellung von Drahtverbindungen weist eine um eine horizontale Achse (2) drehbare Wippe (3) auf. An der Wippe (3) ist ein Horn (5) befestigt, an dessen Spitze (6) eine den Draht (7) führende Kapillare (8) eingespannt ist. An der Wippe (3) ist im Bereich der Spitze (6) des Horns (5) ein Sensor (10) für die Regelung der während des Bondens auf die Kapillare (8) einwirkenden Kraft angeordnet. Der Sensor (10) misst berührungslos die Auslenkung der Spitze (6) des Horns (5) gegenüber der Wippe (3). Zwischen der Auslenkung der Spitze (6) des Horns (5) und der Bondkraft besteht eine Korrelation, die mittels eines Eichvorganges ermittelt und gespeichert wird.

Fig.1

**Beschreibung**

Die Erfindung betrifft einen Ultraschalldrahtbonder mit einem Sensor für die Regelung der Bondkraft der im Oberbegriff des Anspruchs 1 genannten Art.

Aus der europäischen Patentschrift EP 340'506 ist ein Ultraschalldrahtbonder zur Herstellung von Drahtverbindungen der im Oberbegriff des Anspruchs 1 genannten Art bekannt. Der Ultraschallbonder weist eine um eine horizontale Drehachse drehbare Wippe mit einem Horn auf, an dessen Spitze die den Bonddraht führende Kapillare eingespannt ist. An der Wippe sind vier Piezosensoren angeordnet. Sobald die Spitze der Kapillare auf dem Halbleiterchip auftrifft, bewirkt die vom Halbleiterchip auf die Kapillare ausgeübte und auf das Horn und die Wippe übertragene Kraft, dass auf die Piezosensoren Kräfte einwirken. Die von den Piezosensoren gelieferten Signale werden zur Regelung der von der Kapillare auf den Halbleiterchip auszuübenden Kraft benützt. Die Piezosensoren sind relativ schwer, was sich ungünstig auf den Durchsatz des Ultraschallbonders auswirkt.

Aus der europäischen Patentschrift EP 275'877 ist ein Ultraschalldrahtbonder mit einem aus Dehnmessstreifen gebildeten Kraftsensor und einem piezoelektrischen Kraftsensor bekannt, die am Horn angebracht sind. Nachteilig ist, dass diese Sensoren die Eigenschaften des Horns und damit die Ultraschallschwingungen der Kapillare unkontrolliert beeinflussen.

Aus der US-Patentschrift US 5'230'458 ist ein weiterer Ultraschalldrahtbonder mit einem Kraftsensor bekannt. Der Abgriff des Kraftsensors erfolgt aber an einer ungünstigen Stelle, so dass das vom Kraftsensor während des schnell ablaufenden Bondprozesses gelieferte Signal den zeitlichen Verlauf der vom Halbleiterchip auf die Kapillare ausgeübten Kraft verzögert und verfälscht wiedergibt.

Es ist auch bekannt, auf einen Kraftsensor zu verzichten und die von der Kapillare auf den Halbleiterchip einwirkende Kraft aus dem Strom abzuleiten, der den die Wippe antreibenden Motor durchfliesst. Der dynamische Motorstrom hängt allerdings von weiteren Prozessparametern ab wie z.B. der Steifigkeit des Substrates.

Weiter ist es aus den europäischen Patentanmeldungen EP 368'533 und EP 540'189 und der deutschen Patentanmeldung DE 43 37 837 bekannt, die Qualität der Bondverbindung zu überwachen. Dazu ist ein Distanzsensor vorgesehen, der die Deformation der Bondverbindung erfasst.

Der Erfindung liegt die Aufgabe zugrunde, einen für die Regelung der Bondkraft besser geeigneten Sensor vorzuschlagen.

Die genannte Aufgabe wird erfindungsgemäss gelöst durch die Merkmale des Anspruchs 1.

Nachfolgend werden Ausführungsbeispiele der Erfindung anhand der Zeichnung näher erläutert

Es zeigen:

Fig. 1       für das Verständnis der Erfindung nötige Teile eines Ultraschalldrahtbonders, und

Fig. 2 - 6   Sensoren und deren Anordnung am Ultraschallbonder.

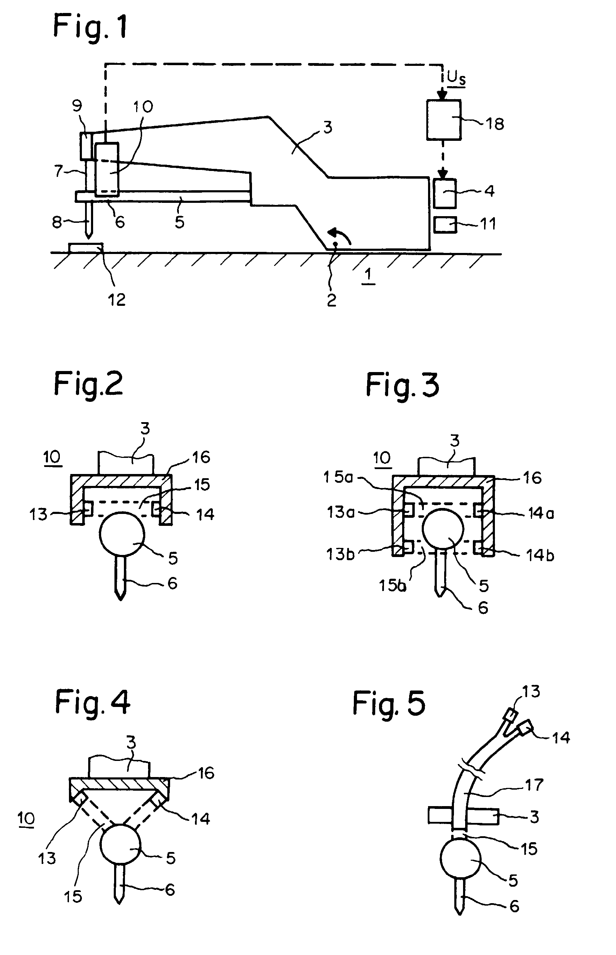

Die Fig. 1 zeigt einen Ultraschalldrahtbonder 1 zur Herstellung von Drahtverbindungen mit einer um eine horizontale Achse 2 drehbaren Wippe 3. Für die Drehbewegung der Wippe 3 ist ein Motor 4 vorgesehen. An der Wippe 3 ist ein Horn 5 befestigt, an dessen Spitze 6 eine den Draht 7 führende Kapillare 8 eingespannt ist. Unter der Spitze 6 des Horns 5 ist der vordere Teil des Hornes 5 vor und hinter der Stelle zu verstehen, wo die Kapillare 8 eingespannt ist. Die Wippe 3 weist weiter eine über der Kapillare 8 angeordnete Drahtklammer 9 auf. An der Wippe 3 ist ein Sensor 10 angeordnet für die berührungslose Messung der Auslenkung der Spitze 6 des Horns 5 gegenüber der Spitze der Wippe 3. Der Sensor 10 arbeitet beispielsweise optisch, induktiv oder kapazitiv. Die Wippe 3 ist in bekannter Weise so konstruiert und als Motor 4 ist vorzugsweise ein Linearmotor vorgesehen, dass sehr grosse Beschleunigungen der Kapillare 8 in vertikaler Richtung möglich sind. Für die Erfassung der momentanen Drehlage der Wippe 3 bezüglich der Achse 2 ist ein Positionsmesssystem 11 vorgesehen. Der Sensor 10 liefert ein Signal $U_S$, das einem den Motor 4 steuernden Steuergerät 18 zugeführt wird.

Das Signal $U_S$ eignet sich ausgezeichnet für die Regelung der während des Bondens auf den Halbleiterchip bzw. auf das Substrat einwirkenden Kraft. Die Arbeitsweise wird nun näher erläutert am Beispiel der Befestigung des Drahtes 7 auf einem Halbleiterchip 12. Zur Bildung eines sogenannten Ball Bondes wird zunächst das aus der Spitze der Kapillare 8 herausragende Drahtende zu einer Kugel geformt. Danach wird die Kapillare 8 durch Drehen der Wippe 3 um die Achse 2 abgesenkt. Sobald die Spitze der Kapillare 8 die Oberfläche des Halbleiterchips 12 berührt, baut sich zwischen der Kapillare 8 und dem Halbleiterchip 12 eine Kraft auf, die sogenannte Bondkraft. Da die Wippe 3 vom Motor 4 weiterhin gedreht wird, die Kapillare 8 aber auf dem Halbleiterchip 12 ansteht, verbiegt sich das Horn 5: Die Spitze 6 des Horns 5 wird gegenüber der Spitze der Wippe 3, wo sich der Sensor 10 befindet und auf die keine Kraft einwirkt, ausgelenkt.

Das vom Sensor 10 gelieferte Signal $U_S$ hängt ab von der Auslenkung der Spitze 6 des Horns 5 gegenüber der Drahtklammer 9, soll aber zur Regelung der Bondkraft verwendet werden. Mittels eines Eichvorganges ist daher die Beziehung zwischen dem Signal $U_S$ des Sensors 10 und der Bondkraft zu ermitteln. Dieser Eichvorgang erfolgt in zwei Schritten:

1. Schritt: Die Spitze 6 des Horns 5 wird mit einem Eichkörper von vorbestimmtem Gewicht, also mit einer vorbestimmten Kraft $F_1$, belastet und dann der Strom $I_{M1}$ gemessen, den der Motor 4 liefern muss, damit sich die Wippe 3 nicht dreht. Dazu wird der Strom durch den Motor 4 so geregelt, bis das Positionsmesssystem 11 anzeigt, dass die Wippe 3 nicht mehr dreht. Daraus wird die Grösse $k_M = F_1/I_{M1}$ berechnet. Dann wird der Eichkörper entfernt.

2. Schritt: Der Motor 4 wird mit dem Strom $I_{M1}$ beaufschlagt, so dass nun die Kapillare 8 mit der Kraft $F_1$ auf die Unterlage drückt, und das vom Sensor 10 gelieferte Signal $U_{S1}$ bestimmt. Danach wird die Grösse

$$k_S = \frac{F_1}{U_{S1}} = \frac{k_M * I_{M1}}{U_{S1}}$$

berechnet.

Der Eichvorgang ist nun abgeschlossen. Im Betrieb des Ultraschallbonders ergibt sich die momentane Bondkraft $F(t)$ aus dem Sensorsignal $U_S(t)$ gemäss der Gleichung

$$F(t) = k_S * U_S(t). \tag{1}$$

Mit dem dynamischen Sensorsignal $U_S(t)$ kann deshalb der Strom $I(t)$ des Motors 4 derart geregelt werden, dass die Bondkraft $F(t)$ einem vorgegebenen zeitlichen Profil folgt.

Die Auslenkung der Spitze 6 des Horns 5 hängt nicht nur von der Bondkraft, sondern auch von weiteren Einflussgrössen, insbesondere von der Umgebungstemperatur ab. Bevorzugt ist deshalb vorgesehen, die Beziehung zwischen der Auslenkung der Spitze 6 des Horns 5 und der Bondkraft während des Betriebes des Ultraschallbonders nachzueichen. Die Nacheichung kann bei Bedarf während jedem Bondvorgang durchgeführt werden und erfolgt so: Sobald während eines Bondvorganges die gewünschte Bondkraft eingeregelt ist, d.h. das aktuelle Signal $U_{S2}$ und der aktuelle Strom $I_{M2}$ durch den Motor 4 stabile Werte erreicht haben, wird die Grösse ksn berechnet zu

$$k_{Sn} = \frac{k_M * I_{M2}}{U_{S2}}.$$

Die Grösse $k_{Sn}$ bezeichnet den aktuell gültigen Wert für die Grösse ks. Es empfiehlt sich jedoch, die Grösse ks nicht aufgrund einer Einzelmessung nachzueichen, sondern z.B. 10 oder 20 aufeinanderfolgende Messungen von ksn dazu heranzuziehen. Bevorzugt wird die Grösse $k_S$ als gleitender Mittelwert über eine vorbestimmte Anzahl Messungen von $k_{Sn}$ nachgeführt und so die Regelung der Bondkraft gemäss Gleichung (1) laufend den aktuellen Einflussbedingungen angepasst.

Die Eichung und die Nacheichung können auch auf andere Arten erfolgen.

Die Erfindung bietet folgende Vorteile:

- Die Bondkraft wird unmittelbar dort gemessen, wo sie auftritt, nämlich bei der Kapillare 8. Die Messung erfolgt zeitverzugslos.

- Die Messung erfolgt berührungslos. Die Ausbreitung der Ultraschallwellen im Horn 5 wird nicht beeinflusst.

- Der Zeitpunkt, an dem die Kapillare 8 auf den Halbleiterchip 12 auftrifft, lässt sich mit dem Sensor 10 praktisch verzugslos erkennen, so dass die Wippe 3 sofort abgebremst werden kann, bevor sich eine zu grosse Bondkraft aufbaut. Zudem setzt die Regelung der Bondkraft unmittelbar nach dem Aufprall der Kapillare 8 ein und wird wegen der hohen Beschleunigungsmöglichkeiten der Wippe 3 voll wirksam. Somit lassen sich die Aufprallgeschwindigkeit der Kapillare 8 und die gewünschte Aufprallkraft optimal aufeinander abstimmen.

- Die Bondkraft erreicht sehr schnell ihren Sollwert und das Horn 5 kann entsprechend frühzeitig mit Ultraschall beaufschlagt werden. Dadurch reduziert sich die Bondzeit für die Herstellung der Bondverbindung und erhöht sich der Durchsatz des Ultraschallbonders.

Die Fig. 2 zeigt ein erstes Ausführungsbeispiel des Sensors 10 und seiner Anordnung an der Wippe 3. Der Sensor 10 weist einen Lichtsender 13 und einen Lichtempfänger 14 auf, die eine Lichtschranke 15 bilden und in einem u-förmigen Gehäuse 16 angeordnet sind. Das Gehäuse 16 ist neben der Drahtklammer 9 in der Nähe der Spitze 6 des Horns 5 an der Wippe 3 befestigt. Der Lichtsender 13 und der Lichtempfänger 14 befinden sich auf je einer Seite des Horns 5 und zwar so, dass sich der obere Rand des Horns 5 immer in der Lichtschranke 15 befindet. Wird nun das Horn 5 gegenüber der Wippe 3 ausgelenkt, dann nimmt die Abschattung der Lichtschranke 15 durch das Horn 5 zu und das Signal $U_S$ des Sensors 10 entsprechend des Grades der Abschattung ab.

Die Fig. 3 zeigt ein zweites Ausführungsbeispiel des Sensors 10. Bei diesem Sensor 10 sind zwei Lichtsender 13a, 13b und zwei Lichtempfänger 14a, 14b vorgesehen zur Bildung von zwei Lichtschranken 15a und 15b. Die erste Lichtschranke 15a ist wie beim ersten Ausführungsbeispiel angeordnet, die zweite Lichtschranke 15b ist parallel zur ersten Lichtschranke 15a angeordnet, jedoch so, dass sich der untere Rand des Horns 5 immer in der zweiten Lichtschranke 15b befindet. Wird nun das Horn 5 gegenüber der Wippe 3 ausgelenkt, dann nimmt die Abschattung der ersten Lichtschranke 15a durch das Horn 5 zu und die Abschattung der zweiten Lichtschranke 15b ab. Das Differenzsignal der beiden Lichtempfänger 14a und 14b dient als Signal $U_S$ des Sensors 10. Die Vorteile dieses Ausführungsbeispieles bestehen in einer höheren Empfindlichkeit des Signals Us und in einer geringeren Abhängigkeit des Signals Us von der Temperatur.

Die Fig. 4 zeigt ein drittes Ausführungsbeispiel des Sensors 10 mit einer reflektiv arbeitenden Lichtschranke 15, bei der das vom Lichtsender 13 abgestrahlte Licht an der Oberseite des Horns 5 teilweise reflektiert und zum Lichtempfänger 14 geleitet wird.

Die Fig. 5 zeigt ein viertes Ausführungsbeispiel des Sensors 10 mit einer reflektiv arbeitenden Lichtschranke 15, bei der das vom Lichtsender 13 abgestrahlte Licht über einen Lichtleiter 17 zur Oberseite des Horns 5 geleitet, dort partiell reflektiert und über den Lichtleiter 17 zurück zum Lichtempfänger 14 geleitet wird.

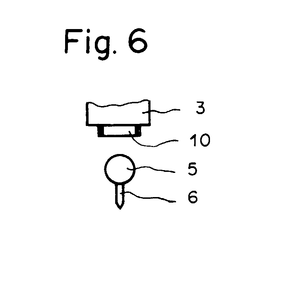

Es ist auch möglich, an Stelle der optischen Elemente im Gehäuse 16 Spulen oder Kondensatorplatten anzubringen und die Auslenkung des Horns 5 induktiv bzw. kapazitiv zu messen. Ein solches Ausführungsbeispiel mit induktiver Abstandsmessung ist in der Fig. 6 dargestellt. Als Sensor 10 dient eine Spule, beispielsweise eine Spule mit einem Ferritkern oder eine Flachspule, die oberhalb der Spitze des Horns 5 an der Wippe 3 angeordnet ist. Die Spule wird mit einem Wechselstrom beaufschlagt und es wird der ohmsche Widerstand und/oder die Induktivität der Spule gemessen. Der ohmsche Widerstand und/oder die Induktivität der Spule ändert, wenn sich der Abstand zum Horn 5 ändert.

Der Sensor 10 kann auch benützt werden, um die Güte der Haftung des gebondeten Drahtes 7 zu ermitteln. Dazu wird der Draht 7 (Fig. 1) nach dem Herstellen der Bondverbindung mit der Drahtklammer 9 festgeklemmt und dann die Wippe 3 hochgefahren. Dabei wird das Drahtstück zwischen der Bondverbindung und der Drahtklammer 9 gespannt und es baut sich eine zunehmende Kraft auf, die die Drahtklammer 9 daran hindert, der Drehbewegung der Wippe 3 zu folgen. Demzufolge wird hier die Drahtklammer 9 gegenüber der Spitze 6 des Horns 5, auf das keine Kraft einwirkt, verbogen, so dass sich der Abstand zwischen der Drahtklammer 9 und dem Horn 5 verkleinert. Somit kann diejenige Auslenkung der Drahtklammer 9 gegenüber dem Horn 5 bestimmt werden, bei der der Draht abreisst. Mit einer Eichprozedur ist die Beziehung zwischen der Auslenkung der Drahtklammer 9 gegenüber dem Horn 5 in Funktion der auf die Drahtklammer 9 einwirkenden Kraft zu bestimmen. Die Kraft, die nötig ist, um den Draht 7 abzureissen, kann so mit hoher Genauigkeit ermittelt werden.

Der Sensor 10 eignet sich weiter dazu, Schwingungen des Horns 5 gegenüber der Wippe 3 zu erkennen, die darauf hindeuten, dass das Horn 5 ungenügend an der Wippe 3 befestigt ist.

**Patentansprüche**

1. Ultraschalldrahtbonder (1) zur Herstellung von Drahtverbindungen, mit einer um eine horizontale Achse (2) drehbaren Wippe (3), an der ein Horn (5) befestigt ist, an dessen Spitze (6) eine den Draht (7) führende Kapillare (8) eingespannt ist, und mit einem Sensor (10) für die Regelung der während des Bondens auf die Kapillare (8) einwirkenden Kraft, **dadurch gekennzeichnet, dass** der Sensor (10) an der Wippe (3) im Bereich der Spitze (6) des Horns (5) angeordnet ist und dass der Sensor (10) berührungslos die Auslenkung der Spitze (6) des Horns (5) gegenüber der Wippe (3) misst.

2. Ultraschalldrahtbonder nach Anspruch 1, **dadurch gekennzeichnet, dass** der Sensor (10) ein optischer Sensor ist.

3. Ultraschalldrahtbonder nach Anspruch 1, **dadurch gekennzeichnet, dass** der Sensor (10) ein induktiver Sensor ist.

Fig.1

Fig.2

Fig.3

Fig.4

Fig.5

# Fig. 6

**Europäisches Patentamt**

# EUROPÄISCHER RECHERCHENBERICHT

Nummer der Anmeldung

EP 00 81 0840

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| D,A | EP 0 340 506 A (ESEC SA) 8. November 1989 (1989-11-08) * Spalte 11, Zeile 6 - Zeile 30; Abbildung 14 * --- | 1-3 | B23K20/10 |
| A | PATENT ABSTRACTS OF JAPAN vol. 018, no. 336 (E-1568), 24. Juni 1994 (1994-06-24) & JP 06 085014 A (TOSHIBA CORP), 25. März 1994 (1994-03-25) * Zusammenfassung * --- | 1-3 | |
| D,A | US 5 230 458 A (ASANASAVEST CHAINARONG) 27. Juli 1993 (1993-07-27) * Abbildungen 4A,4B * ----- | 1-3 | |

**RECHERCHIERTE SACHGEBIETE (Int.Cl.7)**

B23K

Der vorliegende Recherchenbericht wurde für alle Patentansprüche erstellt

| Recherchenort | Abschlußdatum der Recherche | Prüfer |
|---|---|---|
| MÜNCHEN | 29. Dezember 2000 | Pricolo, G |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.......................................................................
& : Mitglied der gleichen Patentfamilie,übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 00 81 0840

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

29-12-2000

| Im Recherchenbericht angeführtes Patentdokument | Datum der Veröffentlichung | Mitglied(er) der Patentfamilie | Datum der Veröffentlichung |
|---|---|---|---|
| EP 0340506 A | 08-11-1989 | CH 678129 A | 31-07-1991 |
| | | AT 101302 T | 15-02-1994 |
| | | DE 58906862 D | 17-03-1994 |
| | | JP 1318243 A | 22-12-1989 |
| | | JP 1893506 C | 26-12-1994 |
| | | JP 6024213 B | 30-03-1994 |
| | | US 4903883 A | 27-02-1990 |
| JP 06085014 A | 25-03-1994 | JP 2074592 C | 25-07-1996 |
| | | JP 7105413 B | 13-11-1995 |
| US 5230458 A | 27-07-1993 | KEINE | |

Für nähere Einzelheiten zu diesem Anhang : siehe Amtsblatt des Europäischen Patentamts, Nr. 12/82